# EUROPEAN PATENT APPLICATION

(11) **EP 4 838 058 A1**
(43) Date of publication of application: **11.11.2026**
(21) Application number: 26172289.6
(22) Date of filing: 14.04.2026
(51) Int. Cl.: F01D 21/00, B25B 13/48

(54) **AIRCRAFT ENGINE INSPECTION SYSTEM**

(30) Priority: 14.04.2025 US 202519178043
(71) Applicant: Pratt & Whitney Canada Corp., Longueuil, Québec J4G 1A1 (CA)
(72) Inventor: HEIN, David, Thornton, 26440 (US); DICAIRE, Jean-Luc, (01BE5) Longueuil, J4G 1A1 (CA)
(74) Representative: Dehns

(57) **Abstract**

An aircraft engine inspection system (40) includes a bore plug (32) received in a bore (31) through a casing (20) of the engine (10). The bore plug (32) has a plug head (33) with an outer surface (33a) and an internal drive (33b) defined therein. The system includes a drive tool (50) and an adapter (60) for interfacing the drive tool (50) with the bore plug (32). The adapter (60) has a main body (61) extending axially from a tail end (61a) to a lead end (61b) with a cavity (62) defined at the lead end (61b). The cavity (62) has an inner surface (62a) engageable over the outer surface (33a) of the plug head (33). The adapter (60) includes a shaft (63) extending axially through the main body (61) with a drive end (63a) and a plug end (63b). The drive end (63a) has a drive recess (65) disposed therein and coupling to the drive tool (50). The plug end (63b) is disposed in the main body cavity (62) and engageable in driving engagement with the internal drive (33b) of the bore plug (32).

## Description

### TECHNICAL FIELD

The disclosure relates generally to aircraft engine tooling and, more particularly, to a an inspection system including a device for removing an inspection hole plug for an aircraft engine.

### BACKGROUND

A gas turbine engine may include one or more inspection holes through its cases or other frames, walls, etc. configured to accommodate access for borescopes and other tools. For example, the inspection holes may allow access for inspection of internal cavities of the gas turbine engine such fluid flow paths, cooling cavities, and the like. The inspection holes may be sealed, for instance via a plug, during operation of the engine to prevent fluid leakage between cavities separated by the adjacent engine cases. There is a need for improved tooling for the removal of inspection hole plugs for gas turbine engine inspection holes.

### SUMMARY

In one aspect of the present invention, there is provided an inspection system for an aircraft engine, comprising: a bore plug received in a bore through a casing of the aircraft engine, the bore plug having a plug head with an outer surface and an internal drive defined in the plug head; a drive tool; and an adapter for interfacing the drive tool with the bore plug, the adapter having a main body extending along an axis from a tail end to a lead end, the main body having a cavity defined at the lead end, the cavity having an inner surface engageable over the outer surface of the plug head, the adapter further including a shaft extending axially through the main body, the shaft having a drive end and a plug end, the drive end having a drive recess disposed therein and coupling to the drive tool, the plug end disposed in the cavity of the main body and engageable in driving engagement with the internal drive of the bore plug.

In certain embodiments, the inspection system as defined above includes one or more of the following features, in whole or in part, and in any combination.

In an embodiment of the above, the shaft is distinct from the main body, the shaft received in an adapter bore extending through the main body.

In an embodiment according to any of the previous embodiments, the shaft is axially displaceable in the adapter bore relative to the main body.

In an embodiment according to any of the previous embodiments, the inspection system further includes a cross-drilled hole through the main body in a direction tangential to the axis; and a pin received through the cross-drilled hole and engaging an outer surface of the shaft to retain the shaft in place relative to the main body.

In an embodiment according to any of the previous embodiments, the pin is received in a slot on the outer surface of the shaft.

In an embodiment according to any of the previous embodiments, the plug end of the shaft includes a spring-loaded ball lock engaging a groove in the internal drive of the plug head of the bore plug.

In an embodiment according to any of the previous embodiments, the inspection system further includes a cooling conduit configured to envelop an outer surface of the main body and a source of cooling fluid flowing the cooling fluid through the cooling conduit.

In another aspect of the present invention, there is provided a method for removing a plug from an inspection bore in an aircraft engine, comprising: encasing an outer surface of a head of the plug in a cavity of an adapter; engaging a plug end of a shaft extending through the adapter with a drive of the head of the plug; coupling a drive tool with a drive end of the shaft opposite the plug end; and imparting, via the shaft, rotation from the drive tool to the head of the plug.

In certain embodiments, the method as defined above includes one or more of the following features, in whole or in part, and in any combination.

In an embodiment of the above, engaging the plug end of the shaft with the drive of the head of the plug includes inserting the shaft through an adapter bore extending through a main body of the adapter, the shaft being distinct from the main body.

In an embodiment according to any of the previous embodiments, the method further includes inserting a pin through a cross-drilled hole in the main body of the adapter, the pin engaging an outer surface of the shaft.

In an embodiment according to any of the previous embodiments, inserting the pin through the cross-drilled hole in the main body of the adapter further includes inserting the pin in a slot on the outer surface of the shaft.

In an embodiment according to any of the previous embodiments, the drive of the plug is a female drive defined in the head of the plug, and wherein the method further comprises engaging a spring-loaded ball lock in the plug end of the shaft with a groove in the female drive in the head of the plug.

In an embodiment according to any of the previous embodiments, the method further includes flowing a cooling fluid in heat exchange relationship with the adapter.

In an embodiment according to any of the previous embodiments, the method further includes, prior to the encasing the outer surface of the head of the plug in the cavity of the adapter, bathing the adapter in a cooling fluid.

In a further aspect of the present invention, there is provided a device for removing a plug from an inspection bore in an aircraft engine, comprising: a main body having a cavity disposed therein, the cavity adapted for surrounding a head of the plug; and a shaft extending through the main body and having a drive end and a plug end, the drive end having a drive recess disposed therein, the plug end disposed in the cavity, the plug end adapted for insertion into a plug recess in the head of the plug.

In certain embodiments, the device as defined above includes one or more of the following features, in whole or in part, and in any combination.

In an embodiment of the above, the shaft is distinct from the main body, the shaft received in an adapter bore extending through the main body.

In an embodiment according to any of the previous embodiments, the shaft is axially displaceable in the adapter bore relative to the main body.

In an embodiment according to any of the previous embodiments, the device further includes a cross-drilled hole through the main body, the cross-drilled hole adapted to receive a pin engaging an outer surface of the shaft to retain the shaft in place relative to the main body.

In an embodiment according to any of the previous embodiments, the device further includes a slot on the outer surface of the shaft adapted to receive the pin.

In an embodiment according to any of the previous embodiments, the plug end of the shaft includes a spring-loaded ball lock adapted to engage a groove in the plug recess in the head of the plug.

### DESCRIPTION OF THE DRAWINGS

Reference is now made to the accompanying figures in which:
FIG. 1 is a schematic cross-sectional view of a gas turbine engine;
FIG. 2 is a schematic cross-sectional view of an inspection system for the engine of FIG. 1, according to some embodiments;
FIG. 3 is a perspective view of a drive tool and an adapter for the inspection system of FIG. 2;
FIGS. 4 and 5 are schematic cross-sectional views showing an exemplary assembly procedure for the inspection system of FIG. 2;
FIG. 6 is a perspective view of a drive tool and an adapter for the inspection system of FIG. 2, according to some embodiments; and
FIG. 7 is a flow chart of an exemplary method for removing a plug from an inspection bore of an aircraft engine.

### DETAILED DESCRIPTION

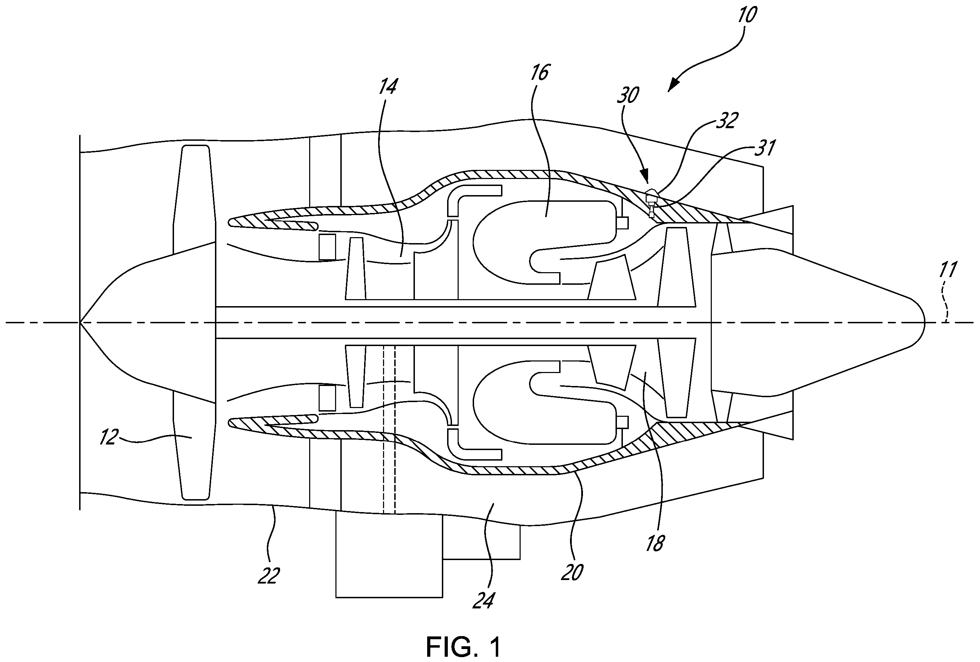

FIG. 1 illustrates a gas turbine engine 10 of a type preferably provided for use in subsonic flight, generally comprising in serial flow communication a fan 12 through which ambient air is propelled, a compressor section 14 for pressurizing the air, a combustor 16 in which the compressed air is mixed with fuel and ignited for generating an annular stream of hot combustion gases, and a turbine section 18 for extracting energy from the combustion gases. A core casing 20 surrounds the compressor section 14, combustor 16, and turbine section 18. A housing or nacelle 22 surrounds the core casing 20 and defines an annular bypass passage 24 therebetween. While FIG. 1 depicts engine 10 as a turbofan engine, it is understood that other aircraft engine types are contemplated.

Still referring to FIG. 1, it is understood that the engine 10 may require inspection at various stages, for instance in repair or maintenance operations. The engine 10 thus includes an inspection bore assembly 30 with a bore 31 extending radially through the casing 20 and a removable bore plug 32 adapted for selectively sealing the bore 31. **In** the shown case, the inspection bore assembly 30 is provided adjacent to the turbine section 18. It is understood, however, that the engine 10 can be provided with one or more inspection bore assemblies at various locations along its axial length. The bore plug 32 is secured to a radially outer end of the bore 31, for instance in a screw-like fashion. As such, to conduct an inspection process using the inspection bore assembly 30, the bore plug 32 is removed (e.g., unscrewed) from the bore 31 so that an inspection tool, for instance a borescope, can be inserted through the bore 31. The bore plug 32 can be subjected to harsh conditions under typical engine operations, for instance excessive heat over multiple flight hours which may render its removal from the bore 31 difficult. While on-wing inspection procedures can be beneficial from a cost and efficiency standpoint, they may exacerbate this difficulty. In particular, the use of a standard drive tool to remove the bore plug 32 can be challenging in such cases due to the potential distortion and stripping of the bore plug 32 after repeated removals.

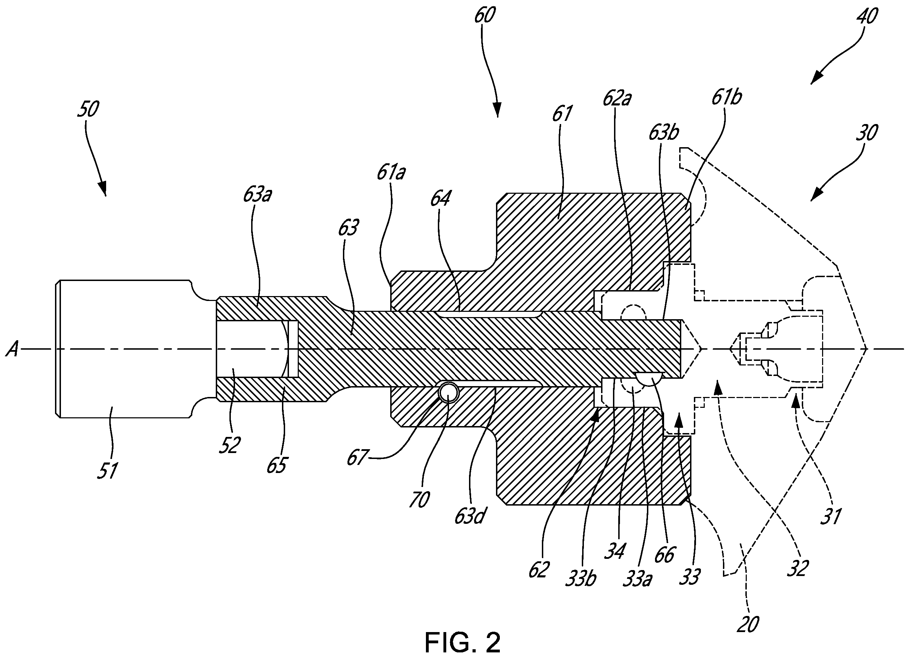

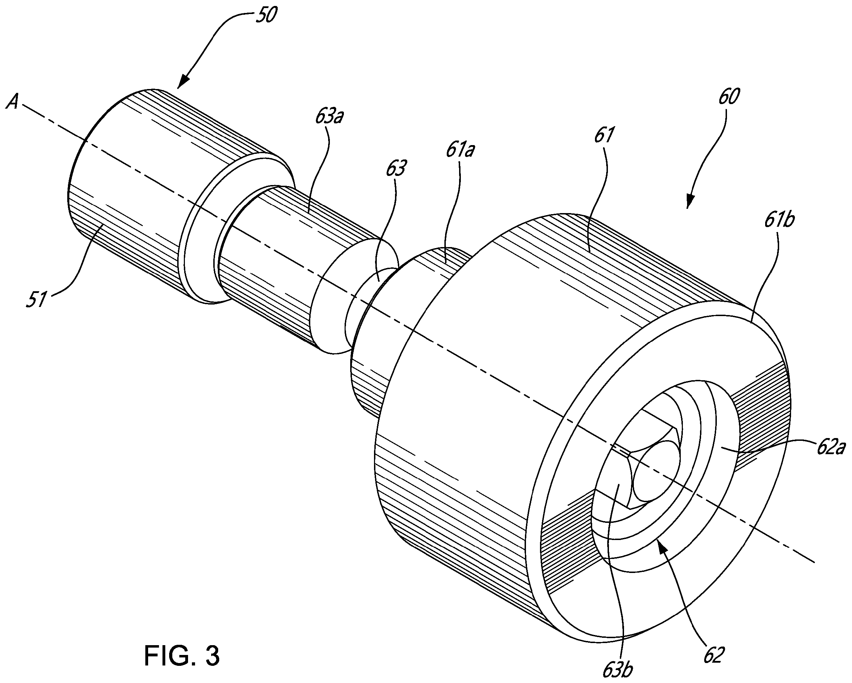

Referring now to FIGS. 2-3, an inspection system 40 is provided for the aircraft engine 10, according to embodiments of the present disclosure. The inspection system 40 includes the bore plug 32, a drive tool 50, and an adapter 60 for interfacing the drive tool 50 with the bore plug 32. In particular, the adapter 60 is adapted for imparting rotation from the drive tool 50 to the bore plug 32 to remove the bore plug 32 from the bore 31. The drive tool 50 includes a drive tool body 51 and a drive element 52. Various drive tool 50 types are contemplated, for instance a torque wrench or a ratchet. The shape and size of the drive element 52 can vary, for instance to correspond with mating components of the adapter 60, as will be discussed in further detail below.

As noted above, the bore plug 32 is removably received in the bore 31 through the casing 20 of the engine 10. The bore plug 32 has a plug head 33 with an outer surface 33a and an internal drive 33b defined in the drive head 33. For instance, in the shown case, the internal drive 33b, also referred to as a plug recess, is square-shaped to mate with a similarly-shaped drive element of the adapter 60. Other shapes for the internal drive 33b are contemplated, for instance hex or 12-point. The outer surface 33a is sized and shaped to secure the bore plug 32 in the bore 31. For instance, the outer surface 33a includes external threading adapted to engage internal threading in the bore 31. Other arrangements for removably securing the bore plug 32 in the bore 31 are contemplated. In embodiments, the shape of the drive element 52 of the drive tool 50 corresponds to the shape of the internal drive 33b as well. In other embodiments, the drive elements of the adapter 60 are shaped differently at opposite ends to engage with different shaped drive elements of the drive tool 50 and the plug head 33. In the shown case, the outer surface 33a of the plug head 33 is circular. Other shapes, for instance square, are contemplated.

Still referring to FIGS. 2-3, the adapter 60 includes a main body 61 extending along an axis A from a tail end 61a to a lead end 61b. A cavity 62 is defined at the lead end 61b of the main body 61. The cavity 62 includes an inner surface 62a adapted to engage or envelop the outer surface 33a of the plug head 33. In the shown case, the inner surface 62a is circular to correspond with the shape of the outer surface 33a of the plug head 33. Other shapes are contemplated. The cavity 62 is thus sized and shaped to snugly engage the outer surface 33a of the plug head 33. Stated differently, the cavity 62 is adapted to engage and support the plug head 33 in a secure manner. The adapter 60 further includes a shaft 63 extending axially through the main body 61. In the shown case, the shaft 63 is distinct from the main body 61 and removably received through an adapter bore 64 extending axially centrally through the main body 61. In other cases, the shaft 63 is integrally formed with the main body 61.

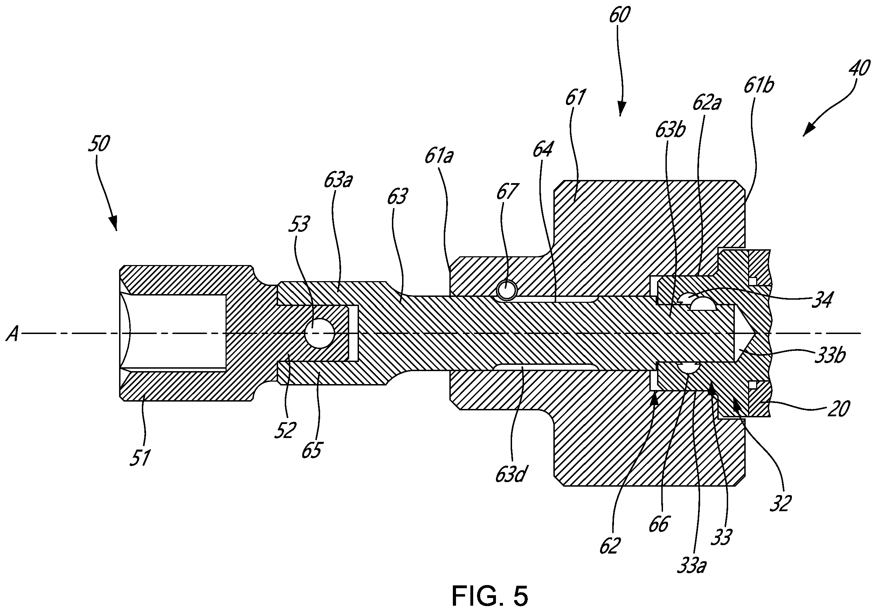

Still referring to FIGS. 2-3, the shaft 63 has a drive end 63a and a plug end 63b. The drive end 63a has a drive recess 65 disposed therein for coupling to the drive tool 50. In particular, the drive recess 65 is sized and shaped to snugly engage the drive element 52 of the drive tool 50 so that rotation from the drive tool 50 can be transferred or imparted through the shaft 63. For instance, in the shown case, the drive element 52 and drive recess 65 are both square-shaped. Other shapes suitable for transferring a torque from the drive tool 50 to the shaft 63 are contemplated. In embodiments, the drive element 52 includes an aperture 53 extending therethrough (see FIGS. 5-6), for instance to engage a protrusion (not shown) in the drive recess 65 for secure engagement. The plug end 63b extends in the cavity 62 of the main body 61 of the adapter 60. The plug end 63b is engageable in driving engagement with the internal drive 33b of the plug head 33 of the bore plug 32, and is thus sized and shaped accordingly. For instance, the plug end 63b has a square shape to correspond with the square-shaped internal drive 33b. Again, any shapes suitable for transferring a torque from the shaft 63 to the bore plug 32 are contemplated. As such, rotation is imparted from the drive tool 50 to the shaft 63 via the drive element 52 engaging the drive recess 65 in the drive end 63a, and from the shaft 63 to the bore plug 32 via the plug end 63b engaging the internal drive 33b of the plug head 33.

Still referring to FIG. 2-3, before or while the shaft 63 engages the plug head 33, the cavity 62 is adapted to snugly engage the outer surface 33a of the plug head 33. As such, the plug head 33 is secured by the main body 61 of the adapter 60 as the plug end 63b of the shaft 63 engages the internal drive 33b of the plug head 33. Stated differently, there is dual engagement between the adapter 60 and the plug head 33: the inner surface 62a of the cavity 62 of the main body 61 snugly engages the outer surface 33a of the plug head 33, and the plug end 63b of the shaft 63 engages the internal drive 33b of the plug head 33. While the torque applied by the shaft 63 can cause the internal drive 33b of the plug head 33 to expand or distort, for instance due to a wedging effect, such distortion is countered by the main body 61 enveloping the plug head 33 and preventing any outward deflection thereof. As such, as rotation is imparted to the plug head 33 by the shaft 63, the outer surface 33a of the plug head 33 is encased in the cavity 62 to secure the plug head 33, thereby increasing its resistance to torque and thus preventing distortion thereof. By securing the plug head 33 as such, the full torque from the drive tool 50 can be transferred to the plug head 33 for the removal of the plug 32 from the bore 31 while minimizing the risk of the plug head 33 distorting and the threading of the plug 32 stripping.

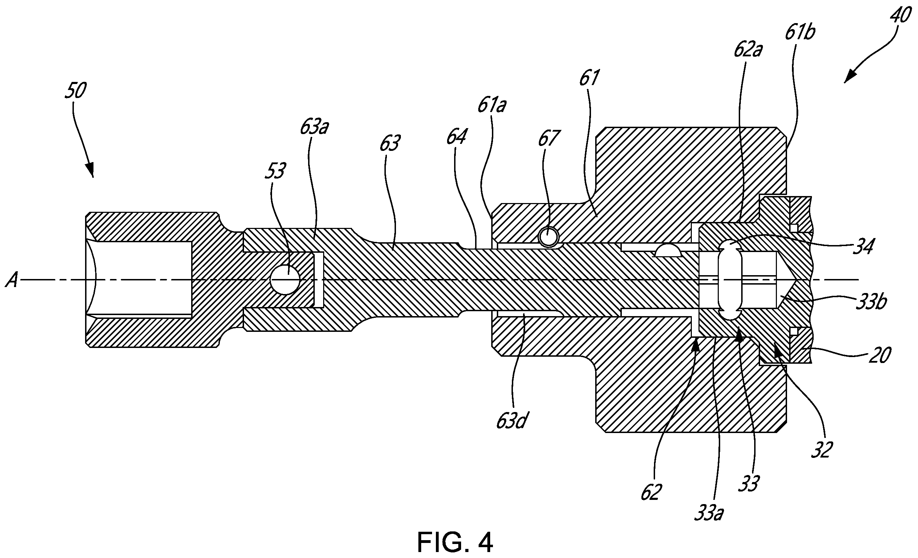

Referring now to FIGS. 4 and 5, in the shown embodiment, the shaft 63 is axially displaceable through the adapter bore 64 relative to the main body 61. As such, in an exemplary removal procedure of the bore plug 32 from the bore 31, the cavity 62 of the main body 61 first snugly engages the outer surface 33a of the plug head 33 before the plug end 63b of the shaft 63 engages the internal drive 33b of the plug head 33, thereby ensuring that the plug head 33 is well supported before engagement by the shaft 63. In addition, the shaft 63 can axially displace to account for manufacturing tolerances of the plug head 33. In an exemplary depiction, FIG. 4 shows the engagement of the main body 61 with the plug head 33 while the shaft 63 is disengaged from the plug head 33. In FIG. 5, the shaft 63 is axially displaced along the axis A towards the plug head 33 for engagement therewith. Once the main body 61 and shaft 63 each engage the plug head 33, the drive tool 50 (see FIG. 2) engages the drive end 63a of the shaft 63 to impart rotation thereto, said rotation transferred to the plug head 33 by the adapter 60. In embodiments, the main body 61 rotate along with the shaft 63 and the plug head 33, for instance due to the tight tolerances between the plug head 33 and main body 61 and/or due to the shapes of the inner surface 62a in the cavity 62 of the main body 61 and the outer surface 33a of the plug head 33 preventing relative rotation of the plug head 33 relative to the main body 61. As such, it is possible to prevent any untorquing force from being applied to the plug head 33 before the main body 61 of the adapter is securing the plug head 33 in place. In the shown case, the plug end 63b of the shaft 63 includes a spring-loaded ball lock 66 adapted to engage a groove 34 in the internal drive 33b of the plug head 33 for additional securement between the shaft 63 and the plug head 33. Other securement configurations between the shaft 63 and plug head 33 are contemplated.

Referring to FIGS. 2 and 4-5, in the shown embodiment, the adapter 60 further includes a cross-drilled hole 67 extending through the main body 61 in a direction tangential to the axis A, illustratively in a direction perpendicular thereto. The cross-drilled hole 67 intersects the adapter bore 64. A pin 70 is insertable through the cross-drilled hole 67 to engage an outer surface 63c of the shaft 63 to limit axial movement of the shaft 63 relative to the main body 61. In addition, in embodiments, the pin 70 rotatably interconnects the main body 61 with the shaft 63 so that the main body 61 rotates with the shaft 63 and plug head 33 as rotation is imparted thereto. **In** the shown case, an axially elongated slot 63d is formed in the outer surface 63c of the shaft 63 to receive the pin 70, with axial ends of the elongated slot 63d acting as stops to delimit axial movement of the shaft 63 relative to the main body 61. In other cases, the slot 63d is omitted. As such, in the above-described exemplary removal procedure of the bore plug 32 from the bore 31, after the shaft 63 is moved into place (i.e., in engagement with the internal drive 33b of the plug head 33), the pin 70 is inserted through the cross-drilled hole 67 to retain the shaft 63 in place relative to the main body 61. Other retainment configurations of the shaft 63 relative to the main body 61 are contemplated. In other cases, for instance, where the shaft 63 is integrally formed with the main body 61, the pin 70 and cross-drilled hole 67 are omitted.

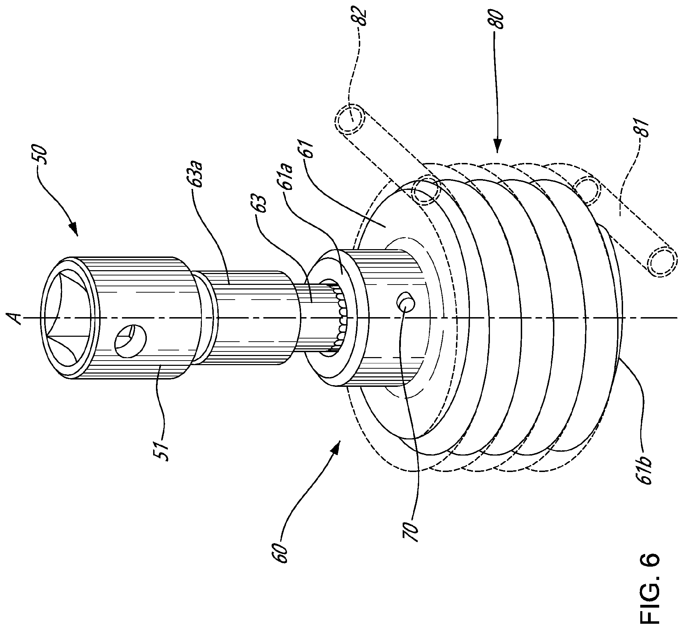

Referring now to FIG. 6, in an embodiment, the inspection system 40 is provided with a cooling conduit 80 for flowing a cooling fluid to cool the adapter 60 before or during a removal procedure. Stated differently, the cooling fluid is flowed through the conduit 80 to be in heat exchange relationship with the adapter 60. In the shown case, the conduit 80, extending between an inlet 81 and an outlet 82, envelops the main body 61 in a spiral-shaped manner to engage a maximum surface area of the main body 61 for heat transfer with the conduit 80. Alternatively, the cooling conduit could be integrally form as part of the main body 61 of the adapter 60. Various cooling fluid types and sources of cooling fluid are contemplated. By cooling the main body 61 before or during a removal procedure, the main body 61 can thermally contract, thereby increasing the snugness of the engagement between the main body 61 and the plug head 33 to further secure the plug head 33 before removal of the plug 32. Such cold-induced snugness can further contribute to tight tolerances between the main body 61 and the plug head 33, further causing the main body 61 to rotate with the shaft 63 and plug head 33. Other configurations for cooling the main body 61 are contemplated. For instance, prior to engaging the main body 61 with the plug head 33, the main body 61 can be bathed in a cooling fluid such a dry ice or liquid nitrogen to promote thermal contraction and a tight fit.

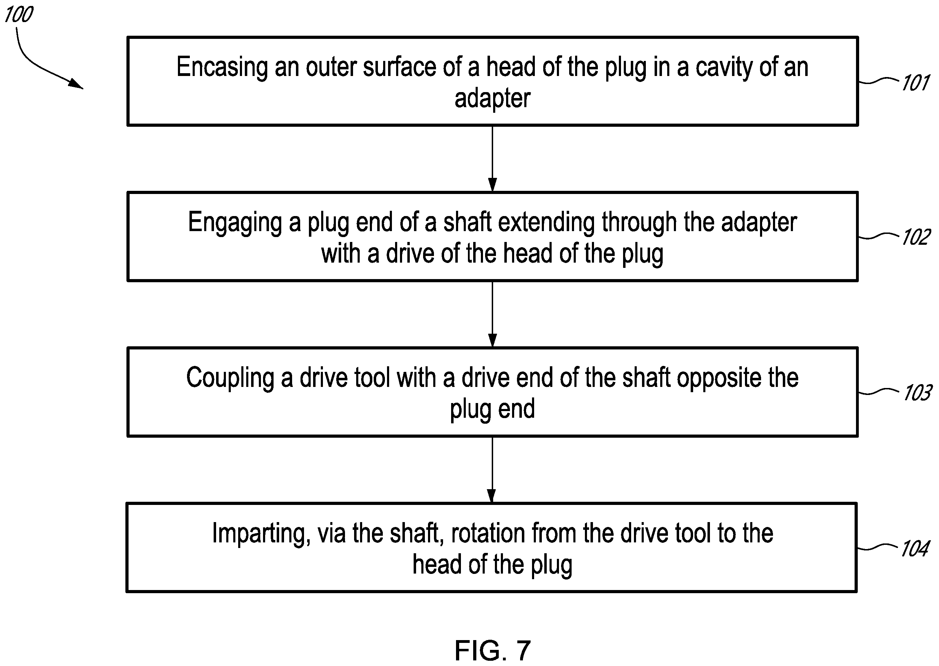

Referring now to FIG. 7, an exemplary method is shown at 100 for removing a plug 32 from an inspection bore 31 in an aircraft engine. At 101, the outer surface 33a of a head 33 of the plug 32 is encased in a cavity 62 of an adapter 60. At 102, a plug end 63b of a shaft 63 extending through the adapter 60 is engaged with a drive 33b in the head 33 of the plug 32. At 103, a drive tool 50 is coupled with a drive end 63a of the shaft 63 opposite the plug end 63b. At 104, rotation from the drive tool 50 is imparted, via the shaft 63 of the adapter 60, to the head 33 of the plug 32. Various additions and modifications to the method 100 are contemplated.

It is noted that various connections are set forth between elements in the preceding description and in the drawings. It is noted that these connections are general and, unless specified otherwise, may be direct or indirect and that this specification is not intended to be limiting in this respect. A coupling between two or more entities may refer to a direct connection or an indirect connection. An indirect connection may incorporate one or more intervening entities. The term "connected" or "coupled to" may therefore include both direct coupling (in which two elements that are coupled to each other contact each other) and indirect coupling (in which at least one additional element is located between the two elements).

It is further noted that various method or process steps for embodiments of the present disclosure are described in the preceding description and drawings. The description may present the method and/or process steps as a particular sequence. However, to the extent that the method or process does not rely on the particular order of steps set forth herein, the method or process should not be limited to the particular sequence of steps described. As one of ordinary skill in the art would appreciate, other sequences of steps may be possible. Therefore, the particular order of the steps set forth in the description should not be construed as a limitation.

Furthermore, no element, component, or method step in the present disclosure is intended to be dedicated to the public regardless of whether the element, component, or method step is explicitly recited in the claims. As used herein, the terms "comprises", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various aspects of the present disclosure have been disclosed, it will be apparent to those of ordinary skill in the art that many more embodiments and implementations are possible within the scope of the present disclosure. For example, the present disclosure as described herein includes several aspects and embodiments that include particular features. Although these particular features may be described individually, it is within the scope of the present disclosure that some or all of these features may be combined with any one of the aspects and remain within the scope of the present disclosure. References to "various embodiments," "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. The use of the indefinite article "a" as used herein with reference to a particular element is intended to encompass "one or more" such elements, and similarly the use of the definite article "the" in reference to a particular element is not intended to exclude the possibility that multiple of such elements may be present.

The embodiments described in this document provide non-limiting examples of possible implementations of the present technology. Upon review of the present disclosure, a person of ordinary skill in the art will recognize that changes may be made to the embodiments described herein without departing from the scope of the present technology. Yet further modifications could be implemented by a person of ordinary skill in the art in view of the present disclosure, which modifications would be within the scope of the present technology.

## Claims

1. An inspection system (40) for an aircraft engine (10), comprising:
a bore plug (32) configured to be received in a bore (31) through a casing (20) of the aircraft engine (10), the bore plug (32) having a plug head (33) with an outer surface (33a) and an internal drive (33b) defined in the plug head (33);
a drive tool (50); and
an adapter (60) for interfacing the drive tool (50) with the bore plug (32), the adapter (60) having a main body (61) extending along an axis (A) from a tail end (61a) to a lead end (61b), the main body (61) having a cavity (62) defined at the lead end (61b), the cavity (62) having an inner surface (62a) engageable over the outer surface (33a) of the plug head (33), the adapter (60) further including a shaft (63) extending axially through the main body (61), the shaft (63) having a drive end (63a) and a plug end (63b), the drive end (63a) having a drive recess (65) disposed therein and coupling to the drive tool (50), the plug end (63b) disposed in the cavity (62) of the main body (61) and engageable in driving engagement with the internal drive (33b) of the bore plug (32).

2. The inspection system (40) as defined in claim 1, wherein the shaft (63) is distinct from the main body (61), the shaft (63) received in an adapter bore (64) extending through the main body (61).

3. The inspection system (40) as defined in claim 2, wherein the shaft (63) is axially displaceable in the adapter bore (64) relative to the main body (61).

4. The inspection system (40) as defined in claim 2 or 3, further comprising:
a cross-drilled hole (67) through the main body (61) in a direction tangential to the axis (A); and
a pin (70) received through the cross-drilled hole (67) and engaging an outer surface (63c) of the shaft (63) to retain the shaft (63) in place relative to the main body (61).

5. The inspection system (40) as defined in claim 4, wherein the pin (70) is received in a slot (63d) on the outer surface (63c) of the shaft (63).

6. The inspection system (40) as described in any of the preceding claims, wherein the plug end (63b) of the shaft (63) includes a spring-loaded ball lock (66) engaging a groove (34) in the internal drive (33b) of the plug head (33) of the bore plug (32).

7. The inspection system (40) as described in any of the preceding claims, further including a cooling conduit (80) configured to envelop an outer surface of the main body (61) and a source of cooling fluid flowing the cooling fluid through the cooling conduit (80).

8. A method for removing a plug (32) from an inspection bore (31) in an aircraft engine (10), comprising:
encasing an outer surface (33a) of a head (33) of the plug (32) in a cavity (62) of an adapter (60);
engaging a plug end (63b) of a shaft (63) extending through the adapter (60) with a drive (33b) of the head (33) of the plug (32);
coupling a drive tool (50) with a drive end (63a) of the shaft (63) opposite the plug end (63b); and
imparting, via the shaft (63), rotation from the drive tool (50) to the head (33) of the plug (32).

9. The method as defined in claim 8, wherein the engaging the plug end (63b) of the shaft (63) with the drive (33b) of the head (33) of the plug (32) includes inserting the shaft (63) through an adapter bore (64) extending through a main body (61) of the adapter (60), the shaft (63) being distinct from the main body (61).

10. The method as defined in claim 9, further comprising inserting a pin (70) through a cross-drilled hole (67) in the main body (61) of the adapter (60), the pin (70) engaging an outer surface (63c) of the shaft (63).

11. The method as defined in claim 10, wherein the inserting the pin (70) through the cross-drilled hole (67) in the main body (61) of the adapter (60) further includes inserting the pin (70) in a slot (63d) on the outer surface (63c) of the shaft (63).

12. The method as described in any of claims 8 to 11, wherein the drive (33b) of the plug (32) is a female drive (33b) defined in the head (33) of the plug (32), and wherein the method further comprises engaging a spring-loaded ball lock (66) in the plug end (63b) of the shaft (63) with a groove (34) in the female drive (33b) in the head (33) of the plug (32).

13. The method as described in any of claims 8 to 12, further comprising flowing a cooling fluid in heat exchange relationship with the adapter (60).

14. The method as described in any of claims 8 to 13, further comprising, prior to the encasing the outer surface (33a) of the head (33) of the plug (32) in the cavity (62) of the adapter (60), bathing the adapter (60) in a cooling fluid.
